# EUROPEAN PATENT SPECIFICATION

(11) **EP 4 129 504 B1**
(45) Date of publication and mention of the grant of the patent: **02.07.2025**
(21) Application number: 21776408.3
(22) Date of filing: 26.02.2021
(51) Int. Cl.: B08B 7/00, H05H 1/46, H01L 21/304, H01J 37/32

(54) **HIGH FREQUENCY REACTION TREATMENT DEVICE AND HIGH FREQUENCY REACTION TREATMENT SYSTEM**
HOCHFREQUENZREAKTIONSBEHANDLUNGSVORRICHTUNG UND HOCHFREQUENZREAKTIONSBEHANDLUNGSSYSTEM
DISPOSITIF DE TRAITEMENT PAR RÉACTION À HAUTE FRÉQUENCE ET SYSTÈME DE TRAITEMENT PAR RÉACTION À HAUTE FRÉQUENCE

(30) Priority: 23.03.2020 JP 2020051160
(43) Date of publication of application: 08.02.2023
(73) Proprietor: SST Inc., Yachiyo-shi, Chiba 276-0049 (JP)
(72) Inventor: TAKAMATSU, Toshiyuki, Yachiyo-shi, Chiba 2760049 (JP)
(74) Representative: Dennemeyer & Associates S.A.
(86) International application number: PCT/JP2021/007258
(87) International publication number: WO 2021/192810

(56) References cited:
- WO-A1-03/096769
- JP-A- 2005 259 633
- JP-A- 2005 259 633
- JP-A- 2017 033 749
- JP-A- H06 291 087
- US-A1- 2005 212 626
- US-B1- 6 204 603

## Description

### Technical Field

The present invention relates to a high frequency reaction processing apparatus and a high frequency reaction processing system for processing a target material with an electromagnetic wave by high frequency excitation.

### Background Art

Patent Document 1 discloses a high frequency reaction processing apparatus in which a propagation line of high frequency waves is formed so as to return in a loop by a cylindrical or spherical dielectric container. The high frequency reaction processing apparatus comprises an outer container formed of a dielectric and an inner container formed of a dielectric disposed inside the outer container, and the high frequency wave coupling portions are provided on outer surface of the outer container, and a covering portion of the conductor which is kept at a ground potential is provided on the other outer surface portion.

The high frequency reaction processing apparatus disclosed in Patent Document 1 can have a large number of strong electric field points due to evanescent surface waves in the reaction processing region inside the inner container. Further, it is possible to propagate the electromagnetic wave from the high frequency waveguide line to the direction of the infinitely long dielectric propagation line, it can configure a large infinitely long dielectric transmission line with a large area. Further examples of prior art high frequency reaction processing systems using microwaves are disclosed in Patent documents 2-4.

### Prior Art Literature

### Patent Literature

[Patent Document 1] Japanese Patent No. 3637397
[Patent Document 2] United States Patent No. 2005/212626 A1
[Patent Document 3] Japanese Patent No. 2005 259633 A
[Patent Document 4] United States Patent No. 6 204 603 B1

### Disclosure of the Invention

### Problem to be Solved by the Invention

In the high frequency reaction processing apparatus described in Patent document 1, an infinitely long dielectric propagation line is configured. The infinitely long dielectric propagation line refers to a high frequency wave propagation line that returns in a loop by a cylindrical or spherical dielectric container. Then, by propagating the electromagnetic wave from the high frequency waveguide line to the direction of the infinitely long dielectric propagation line, evanescent waves are generated and propagated continuously inside the inner container, the supplied energy of the high frequency wave is absorbed by the load inside the inner container.

However, when a load inside the inner container to be subjected to the reaction has poor absorption efficiency, energy of the high frequency is not efficiently absorbed by the internal load. Then, a part of the energy of the electromagnetic wave that continuously returns and passes through the infinitely long dielectric propagation line by the outer container in a loop is absorbed by the dielectric loss of the dielectric material, and a part of the loss is consumed as heat loss.

The present invention has been made in view of the above circumstances, and an object thereof is to provide a high frequency reaction processing apparatus and a high frequency reaction processing system capable of reducing a loss of energy of an electromagnetic wave continuously returning to and passing through a propagation line in a loop.

Therefore, according to the invention, there is provided a high frequency reaction processing system according to claim 1. Further preferred embodiments are defined in the dependent claims.

### Means for Solving the Problem

(1) In order to achieve the above objectives, the high frequency wave response processing apparatus of the present invention comprises an outer container made of a dielectric material and having an inner cavity capable of being closed by two end faces, a covering portion made of a conductive material and kept at the same potential as ground potential of a high frequency waveguide, at least one high frequency wave coupling portion provided at any position of an outer surface of the covering portion, and at least one inner container made of a dielectric material, provided at a position for receiving a high frequency wave travelling through the high frequency wave coupling portion without touching an inner side face of the outer container and having an inner cavity capable of being closed by two end faces, wherein a reaction process is performed by electromagnetic waves guided from the high frequency wave coupling portion in the inner cavity of the inner container.
   Thus, by providing a space between the covering portion and the outer container for the evanescent wave generated by the outer container of dielectric, absorption of the electromagnetic wave by the outer container can be suppressed and the processing efficiency can be improved.
(2) Further, the high frequency reaction processing apparatus of the present invention further comprises a lid portion made of conductor kept at the same potential as ground potential of the high frequency waveguide, the lid portion closing the inner cavity of the inner container at an end face of the inner container, wherein the lid portion has a fitting groove for fitting an end part of the inner container, and the fitting groove has a depth with a length of 1/8 wavelength or more and 1/2 wavelength or less of the guided high frequency wave and accommodates an end part of the inner container without contacting a side surface of the inner container. Thus, since the electromagnetic wave is choked without entering the fitting groove, it is possible to keep a low temperature of the end portion of the inner container.
(3) Further, the high frequency reaction processing system of the present invention comprises a plurality of the high frequency reaction processing apparatuses according to any one of the above and a single processing chamber connected to the inner cavity of the inner container via an end face on one side of the inner container of each of the plurality of high frequency reaction processing apparatuses. Thus, a processing reaction with a large output can be expanded to a large area.

### Advantageous Effect of the Invention

According to the present invention, it is possible to reduce a loss of energy of an electromagnetic wave continuously returning to and passing through a propagation line in a loop.

### Brief Description of the Drawings

Figs. 1A and 1B are respectively a cross-sectional plan view and a cross-sectional front view on y1-y2 of the high frequency reaction processing apparatus according to the first embodiment.
Fig. 2 is an enlarged cross-sectional front view of the high frequency reaction processing apparatus according to the first embodiment.
Figs. 3A and 3B are respectively a cross-sectional plan view and a cross-sectional front view on y1-y2 of the high frequency reaction processing apparatus according to the second embodiment.
Fig. 4 is an enlarged cross-sectional front view of the high frequency reaction processing apparatus according to the second embodiment.
Figs. 5A and 5B are respectively a cross-sectional plan view and a cross-sectional front view on y1-y2 of the high frequency reaction processing system according to the third embodiment.

### Best Modes for Carrying Out the Invention

### [First Embodiment]

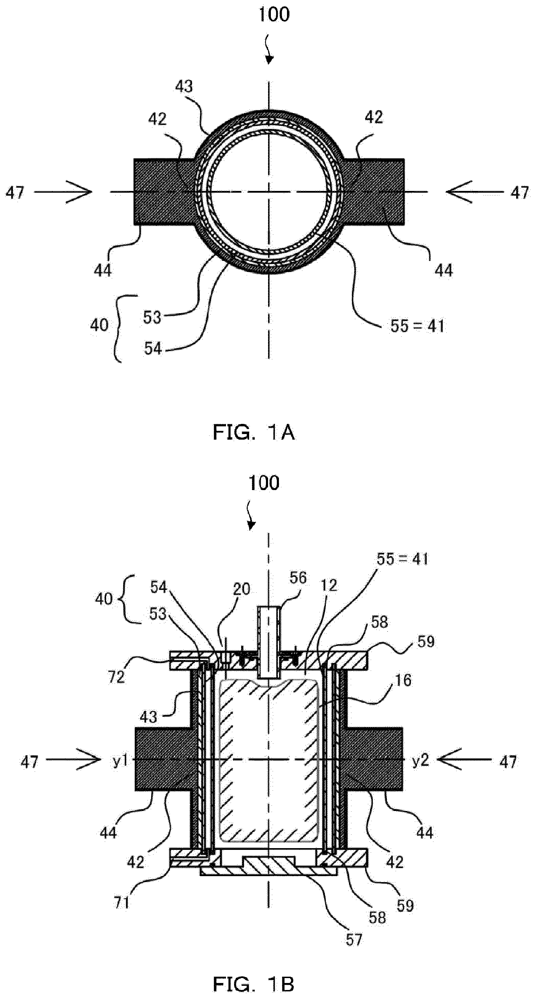

Figs. 1A and 1B are respectively a plan cross-sectional view and a front cross-sectional view on y1-y2 of the high frequency reaction processing apparatus 100 according to the first embodiment. The high frequency reaction processing apparatus 100 comprises a dielectric outer container 40 (outer container), a covering conductor 43 (covering portion), high frequency wave coupling portions 42, a dielectric inner container 41 (inner container) and vacuum container walls 59 (lid portions). The dielectric outer container 40 is configured of a fluororesin film layer 53 and a quartz tube 54. The dielectric inner container 41 is configured of a quartz tube 55. The high frequency wave coupling portion 42 is provided at any position of the outer surface of the covering conductor 43. A plurality of high frequency wave coupling portions 42 may be provided for one covering conductor 43.

The dielectric inner container 41 is made of a dielectric material and is provided at a position for receiving a high frequency wave traveling through the high frequency wave coupling portion 42 without contacting the inner side face of the dielectric outer container 40. The dielectric inner container 41 has an inner cavity (inner space) closed by two end faces formed by vacuum container walls 59. A plurality of dielectric inner containers 41 may be provided for one outer container. The high frequency reaction processing apparatus 100 performs reaction processing by electromagnetic waves guided from the high frequency wave coupling portions 42 in the inner cavity of the dielectric inner container 41.

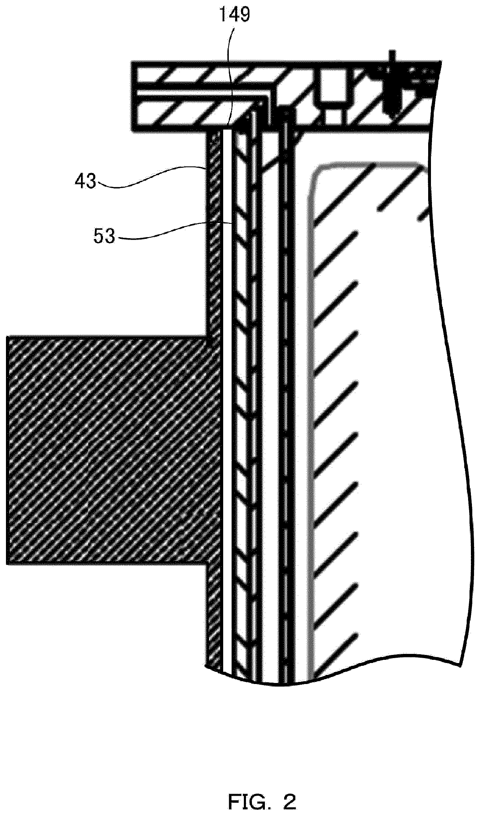

As shown in Figs. 1A and 1B, the high frequency reaction processing apparatus 100 can configure a discharge portion of a high frequency plasma apparatus. y1-y2 represents a center line parallel to high frequency waveguides (hereinafter, the same). Fig. 2 is an enlarged front cross-sectional view of the high frequency reaction processing apparatus 100 according to the first embodiment.

The dielectric outer container 40 is made of a dielectric material, and its inner cavity (inner space) is closed by two end faces configured of vacuum container walls 59 (lid portions). The covering conductor 43 is made of a conductive material to form a spatial region 149 with the outer surface of the dielectric outer container 40 and is kept at the same potential as the ground potential of the high frequency waveguide. Thus, although evanescent wave is generated by the dielectric outer container 40 on the inside of the covering conductor 43 serving as a waveguide, the absorption of electromagnetic waves by the dielectric outer container 40 is suppressed by providing the spatial region 149 between the covering conductor 43 and the dielectric outer container 40 to improve the processing efficiency.

The spatial region 149 is preferably formed by separating 1/60 wavelength or more 1/4 wavelength or less of the traveling high frequency wave between the inner surface of the covering conductor 43 and the outer surface of the dielectric outer container 40. Thus, it is possible to provide the dielectric inner container 41 at a position of 1/4 wavelength from the inner side face of the covering conductor 43, which is corresponding to the peak of the evanescent wave, and to improve the processing efficiency.

The vacuum container walls 59 are formed on the respective end faces of the dielectric inner container 41, the dielectric outer container 40 and the covering conductor 43. The vacuum container walls 59 are configured of conductors kept at the same potential as the ground potential of the high frequency waveguide, to close the inner cavity of the dielectric inner container 41 and the dielectric outer container 40 at the end faces of the dielectric outer container 40 and the dielectric inner container 41. The vacuum container wall 59 has a locking portion for holding the dielectric outer container 40 apart from the covering conductor 43. Thus, a constant distance can be arranged between the inner surface of the covering conductor 43 and the outer surface of the dielectric outer container 40. The locking portion can be formed, for example, as a groove into which the covering conductor 43 is fitted.

As shown in Figs. 1A and 1B, in the high frequency reaction processing apparatus 100, high frequency waves 47 are emitted from two microwave oscillating portions and are guided into a vacuum container 12 through the high frequency waveguides 44. The vacuum container 12 functions as a central part of the discharge portion. The high frequency waveguide 44 refers to a propagation line of high frequency wave formed by a waveguide or waveguide and spatial region.

The vacuum container 12 is configured of a cylindrical quartz tube 55 as the dielectric container 41 and the upper and lower aluminum vacuum container walls 59 and an aluminum door sample stage 57 and sealed for vacuum by O-rings 58. In the vacuum container wall 59, a decompression exhaust port 56 is provided for exhausting gas and reducing pressure. A gas for generating plasma is introduced from a process gas inlet 20 while the flow rate is controlled.

The process up to the plasma generation using the high frequency reaction processing apparatus 100 configured as described above is outlined as blow. After the target sample is placed on the door sample stage 57 in the atmosphere, the door sample stage 57 is raised, and the contact seal connection is made by O-ring at the lower vacuum container wall 59. The vacuum container 12 is depressurized, and a predetermined process gas is introduced from the process gas inlet 20. By introducing a high frequency electromagnetic wave along the traveling direction of the high frequency wave 47, a high frequency plasma having a plasma boundary plane 16 is generated in the vacuum container 12.

The dielectric outer container 40 is configured of a fluororesin film layer 53 and a quartz tube 54, and the quartz tube 54 is coated on an outer side face with a fluororesin film layer 53 The spatial region 149 is provided between the outer side face of the fluororesin film layer 53 (i.e., the outer surface of the dielectric outer container 40) and the aluminum covering conductor 43 is a ground potential, the high frequency waveguide 44 is formed by the covering conductor 43 and the spatial region 149. The high frequency waveguide 44 is a spatial line in the waveguide surrounded by the covering conductor 43 which is grounded, and the line according to the waveguide is formed by extending connection to the spatial region 149.

A covering conductor 43 is also electrically connected to vacuum container walls 59 made of aluminum. In the present embodiment, the dielectric inner container 41 is disposed inside and coaxially of the dielectric outer container 40 so that the distance from the inner side face of the dielectric inner container 41 to the outer side face of a fluororesin film layer 53 in the dielectric outer container 40 is 1/4 wavelength of the high frequency wave to be guided.

In addition, for the purpose of cooling the dielectric outer container 40 and the dielectric inner container 41, a structure is adopted in which a gas or a liquid having a small dielectric constant flows from a cooling medium inlet 71 in the vacuum container wall 59 on the lower side into a region between the dielectric outer container 40 and the dielectric inner container 41, and the gas or the liquid is discharged from a cooling medium outlet 72 in the vacuum container wall 59 on the upper side.

The high frequency wave coupling portion 42 connects the high frequency waveguide 44 with the dielectric outer container 40, and the high frequency wave 47 propagates along the high frequency waveguide 44 via the high frequency wave coupling portion 42. The spatial region 149 between the dielectric outer container 40 and the aluminum covering conductor 43 functions as a high frequency waveguide 44. Although the electric field direction generally varies depending on the electromagnetic wave mode of the high frequency wave 47, in the high frequency reaction processing apparatus 100, the electric field direction is configured so that the electromagnetic wave propagates in the circular tube circumferential direction of the dielectric outer container 40, which is a circular tube, using a TM11 mode. As a result, an infinitely long dielectric propagation line in which the electromagnetic wave returns on the side surface of the circular tube in a loop is formed.

The length of the inner contour in the front cross section of the dielectric outer container 40 is designed to be an integral multiple of 1/4 wavelength of the high frequency wave to be guided. Thus, the high frequency wave 47 which propagates along with the circumferential direction of the dielectric outer container 40 as a dielectric propagation line causes a resonance of the propagation line.

Further, the high frequency waveguide 44 of cavity by the spatial region between the outer side face of the dielectric outer container 40 and the grounded covering conductor 43 is formed, and it is possible to reduce the attenuation of high frequency wave in the infinitely long dielectric propagation line to return in a loop. Thus, the electromagnetic wave does not leak outward, and the surface wave forming a leakage electric field are generated widely along the propagation line in the inner radial direction of the dielectric outer container 40. Further, the covering conductor 43 is kept at a ground potential. Thus, a large number of points with high electric field is widely generated in a loop at a position of an integer multiple of 1/4 wavelength of the surface wave guided into the inside of the conductor surface.

As described above, the position of the inner side face of the dielectric inner container 41 configuring the wall surface of the vacuum container 12 coincides with the point with the high electric field of the surface wave. Thus, plasma can be generated in the vacuum chamber 12 easily and instantaneously from the introduction of the high frequency wave 47.

When plasma is generated, a plasma boundary plane16 is formed inside the dielectric inner container 41. Because the plasma itself has a variable impedance, a part of the surface wave is absorbed by the plasma, and other parts of the surface wave is reflected by the plasma boundary plane 16. The reflected wave repeats alternately reflection and propagation in the region formed by the plasma boundary plane 16 via the dielectric outer container 40 and the dielectric inner container 41 by the covering conductor 43.

The propagation line impedance of the high frequency wave in this region varies in conjunction with the impedance of the plasma. Then, this region forms a matching circuit of 1/4 wavelength impedance transformer. Thus, resonance occurs in conjunction with the plasma. As a result, impedance matching between the propagation line and the plasma load is achieved, and eventually electromagnetic wave energy is efficiently absorbed into the plasma load.

Further, with an increase in the introduced power, the plasma density increases and the plasma boundary plane 16 begins to have a property close to the conductor. Then, even if the reflection standing wave in the propagation line of the 1/4 wavelength impedance transformer is increased, a capacitance property of the propagation line is increased to form a parallel resonant circuit as a whole. Therefore, the increase of the reflection standing wave works in the direction to increase the current value for the plasma load, and the plasma ionization efficiency increases. Thus, no reflected wave is returned to the high frequency waveguide 44, the non-reflection state is realized when the load is viewed from the oscillation side.

Further, the vacuum container 12 functions as a cylindrical cavity resonator when there is no plasma load as a whole and functions as a dielectric resonator when there is a plasma load. Therefore, power can be efficiently absorbed in the load.

As shown in Figs. 1A and 1B, even when high frequency waves 47 are guided from a plurality of high frequency waveguide 44, the standing wave is confined in an area corresponding to the matching circuit of the 1/4 wavelength impedance transformer. Thus, a plurality of oscillating portions can inject power into the load without interfering with each other, and thereby a large power is obtained for the apparatus.

Here, specific dimensions and capacities of the high frequency reaction processing apparatus of the present embodiment are shown as an example. The frequency of the high frequency wave 47 is 2.45GHz, the electromagnetic wave mode thereof is TM11 mode, and the maximal power thereof is 1kW. The high frequency wave coupling portion 42 connects to the dielectric outer container 40 at the opening of the width 70mm height 130mm. A quartz tube 54 having an outer diameter of 150mm, thick of 3mm and Z-axis direction length of 200mm is coated on an outer side face with a fluororesin film layer 53 made of PTFE having a thickness of 2mm, and the dielectric outer container 40 is formed by them. The dielectric inner container 41 is formed of a quartz tube 55 having an outer diameter of 115mm, thick of 3mm and Z-axis direction length of 200mm. The covering conductor 43 made of aluminum is formed of an aluminum plate having a thickness of 0.5mm. A spatial region of 3mm is provided between the covering conductor 43 made of aluminum and the outer side face of the dielectric outer container 40 whose outer side face is coated with the fluororesin film layer 53 made of PTFE having a thickness of 2mm.

The vacuum container wall 59 made of aluminum is formed in a disc shape having a thickness of 20mm and outer diameter of 200mm, the vacuum container wall on the lower side has a hole of 100mm diameter at its center, and the hole is closed by the door sample stage. The decompression exhaust port 56 is a tube having an inner diameter of 20mm and an outer diameter of 1 inch and is connected to a vacuum pipe from a vacuum pump by a connection joint of O-ring seal. The cooling medium inlet 71 is connected with a joint of 1/4 inch gas pipe and supplies dry air at 30psi for cooling.

In the present embodiment, the process gas inlet 20 and the decompression exhaust port 56 are provided in the same vacuum container wall 59, but they may be provided separately on the opposing vacuum container walls 59.

### [Example 1-1]

A test example of plasma generation in the present embodiment is described below. A high frequency reaction processing apparatus according to the above configuration example was used. As the vacuum condition, the pressure was set to 13Pa to 1000Pa, and N₂, O₂ and a mixed gas thereof were used. The gas flow rate was 50cc/min to 300cc/min. As microwave power, 2 units were supplied for 50W to 1000W per unit. As for the vacuum pump system, a rotary pump with pumping quantity 1000L/min was used. The degree of vacuum was measured by a pirani vacuum gauge on a vacuum exhaust line. The pressure was adjusted by adjusting the opening and closing of the manual switching valve on the vacuum exhaust line. The plasma discharge was obtained instantaneously from power input under all the above generating conditions. Then, plasma with uniform plasma emission was obtained throughout the vacuum container. Even if continuous operation was performed for 1000 hours or more, no abnormality was observed in the magnetron oscillating portion.

### [Example 1-2]

A test example of the processing efficiency in the present embodiment is described below. As a sample, an organic photoresist having a thickness of 2µm coated on a silicon substrate having an area of 20cm² was used to test the stripping rate. As process conditions, the substrate temperature was set to room temperature, the microwave power was set to 500W, the process gas was set to oxygen (100 cc/min), the process pressure was set to 150Pa, and the process time was set to 20 seconds. In the high frequency reaction processing apparatus of the present example, the photoresist stripping rate was 4µm/min. This is a result of 150% over the prior art. In the conventional high frequency reaction processing apparatus as a comparative example, it was different only that the inner diameter of the covering conductor made of aluminum coincided with the outer diameter of the dielectric outer container not to provide a spatial region, and other conditions were the same. The substrate temperature after the process was measured to be about 60° C, and the organic matter stripping could be performed at high speed without increasing the substrate temperature.

In the case of using an ordinary organic matter stripping apparatus using oxygen microwave plasma, the stripping rate increases as the substrate temperature rises. In the case, unless the temperature of the substrate is raised to more than 140 degrees, which is the glass transition point of the organic resist film, a stripping rate of 1µm/min or more cannot be obtained. The reason why the substrate temperature did not rise and the stripping speed is high in the high frequency reaction processing apparatus of the present example can be determined to be that the high-density excited plasma was generated in the plasma boundary plane 16 in the vicinity of the inner wall part of the dielectric inner container 41 and that a large amount of oxygen radicals were generated.

### [Second Embodiment]

In the above embodiment, when the load inside the inner container is a decompression plasma discharge, the plasma discharge body diffuses to the entire inner container, the gas introducing portion and the decompression pipe portion. Since the plasma discharge body is a conductor, the high frequency wave propagates in the plasma discharge body and also to the decompression seal portion in the outer end face of the inner container. Then, as a result of that the high frequency wave is absorbed by the sealing material having a dielectric loss, the sealing material is deteriorated by heat, and eventually the hermetic seal is deteriorated. In addition, absorption of ultraviolet ray by luminescence radiation of the plasma discharge body and heat generated thereby also provide affection. It is a subject matter to cut off the vacuum ultraviolet ray by electroluminescence and the electromagnetic wave to the member at the end of the inner container.

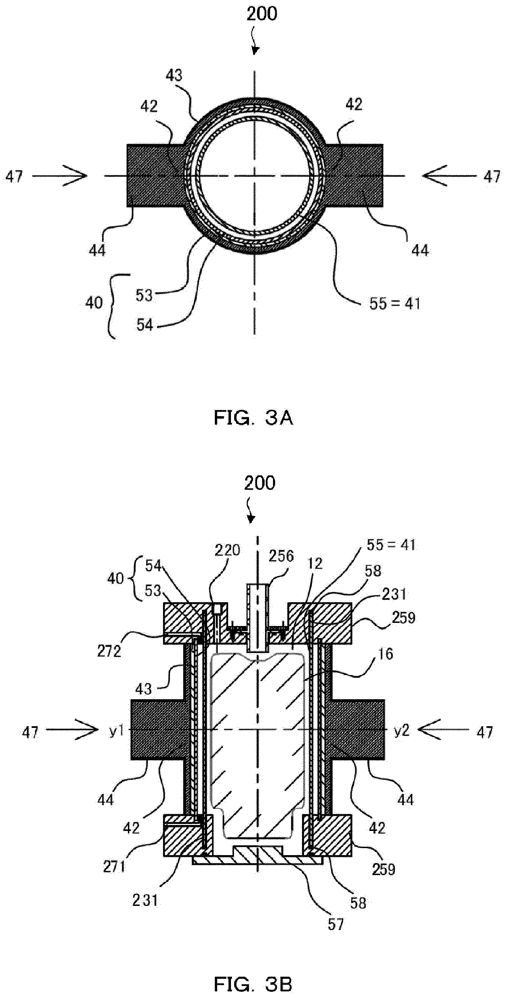

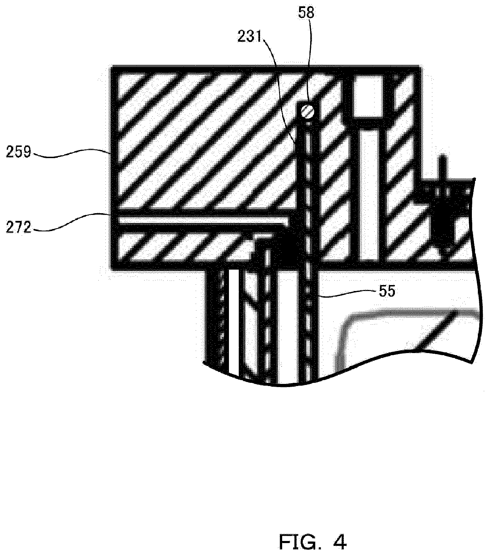

Figs. 3A and 3B are respectively a cross-sectional plan view and a cross-sectional front view on y1-y2 of the high frequency reaction processing apparatus 200 according to the second embodiment. The high frequency reaction processing apparatus 200 comprises a dielectric outer container 40 (outer container), a covering conductor 43 (covering portion), high frequency wave coupling portions 42, a dielectric inner container 41 (inner container) and vacuum container walls 259 (lid portions). The dielectric outer container 40 is configured of a fluororesin film layer 53 and a quartz tube 54. The dielectric inner container 41 is configured of a quartz tube 55. As shown in Figs. 3A and 3B, the high frequency reaction processing apparatus 200 can constitute a discharge portion of a high frequency plasma apparatus. Fig. 4 is an enlarged cross-sectional front view showing the high frequency reaction processing apparatus 200.

The vacuum container wall 259 comprises a groove 231 (fitting groove) for fitting the end of the dielectric inner container 41. The groove 231 has a depth with a length of 1/8 wavelength or more and 1/2 wavelength or less of the wavelength of the high frequency wave to be guided and accommodates the end of the dielectric inner container 41 without contacting with the side surface of the dielectric inner container 41. Thus, since the electromagnetic wave is choked without entering the groove 231, it is possible to keep a low temperature of the end part of the dielectric inner container 41. The groove 231 has a depth of 1/4 wavelength or more of the wavelength of the high frequency wave to be guided. Thus, the high frequency wave can be choked so as not to lead to the end part of the dielectric inner container 41.

An O-ring 58 (seal member) is provided between the dielectric inner container 41 and the vacuum container wall 259 to seal the inner cavity of the dielectric inner container 41. The O-ring 58 is provided at any of the positions accommodated by the groove 231. Thus, the temperature of the O-ring 58 for sealing the dielectric inner container 41 can be kept low, it is possible to prevent damage to the O-ring 58.

The dielectric inner container 41 can be made of alumina. Thus, it is possible to improve the durability against corrosive gas at high temperatures. For example, that is effective in the case of generating plasma in the inner cavity of the dielectric inner container 41. As a result, plasma can be generated with high efficiency.

In the case where the reaction processing of the target material is performed by the electromagnetic wave guided from the high frequency wave coupling portion in the inner cavity of the dielectric inner container 41, it is preferable that the dielectric inner container 41 is made of quartz. As a result, it can be applied to decomposition of fluorocarbon and scrubbers.

As in the first embodiment, the vacuum container 12 is configured of the cylindrical quartz tube 55, aluminum vacuum container walls 59 on the upper and lower sides and an aluminum door sample stage 57 and is vacuum-sealed by the O-rings 58. The dielectric inner container 41 is configured of a quartz tube 55. The present embodiment is not limited to the modification from the first embodiment and may be a modification from a high frequency reaction processing apparatus without the spatial region.

In the first embodiment, the O-ring 58 may be subjected to exposure deterioration due to long-term use of the apparatus and conditions of use due to absorption of leaked electromagnetic waves, heat and plasma discharge vacuum ultraviolet ray from the high frequency plasma having the plasma boundary plane 16 generated within the vacuum container 12.

In the present embodiment, the grooves 231 having a width of 1/8 wavelength or less and a depth of 1/4 wavelength or more of the high frequency wave used are respectively formed in the aluminum vacuum container walls 259 on the upper and lower sides. Then, the seal parts for both end faces of the cylindrical quartz tube 55 are provided inside the groove 231.

This structure chokes the high frequency wave, and the high frequency wave does not leak to the seal part configured in the groove. Further, the vacuum ultraviolet ray of the plasma discharge is shielded by the above groove to suppress the deterioration of the O-ring.

Further, it is preferable that the inside of the aluminum vacuum container walls 259 on the upper and lower sides have water cooling structures. Thus, it is also possible to deal with deterioration caused by heat.

As a result, the deterioration of the decompression seal can be suppressed even under severe conditions in continuous high-power high-density plasma generation for a long time, and maintenance-free is realized.

Here, specific dimensions and capacities of the high frequency reaction processing apparatus according to the present embodiment are shown as an example. The frequency of the high frequency wave 47 is 2.45GHz, the electromagnetic wave mode thereof is TM11 mode, and the maximal power thereof is 1kW. The high frequency wave coupling portion 42 connects to the dielectric outer container 40 at the opening having the width of 70mm and height of 130mm. The dielectric outer container 40 is formed by a quartz tube 54 having an outer diameter of 150mm, a thickness of 3mm and Z-axis length of 200mm and a fluororesin film layer 53 made of PTFE having a thickness of 2mm covering the outer side face of the quartz tube 54.

The dielectric inner container 41 is formed by a quartz tube 55 having an outer diameter of 115mm, a thickness of 3mm and Z-axis direction length of 260mm. The covering conductor 43 made of aluminum is formed by an aluminum plate having a thickness of 0.5mm. A spatial region of 3mm is provided between the outer side face of the aluminum covering conductor 43 and the dielectric outer container 40.

The vacuum container wall 259 made of aluminum is a disc-shaped member having a thickness of 50mm and outer diameter of 200mm and is water-cooled with a water-cooling channel. Further, the groove 231 is formed with an outer diameter of 160mm, inner diameter of 140mm and depth of 30mm.

The vacuum container wall on the lower side has a hole with a diameter of 100mm in the center, and the hole is closed by the door sample stage. The decompression exhaust port 256 is a tube having an inner diameter of 20mm and an outer diameter of 1 inch and is connected to a vacuum pipe from the vacuum pump by a connection joint having an O-ring seal. The cooling medium inlet 71 is connected to a 1/4 inch gas pipe joint, and dry air for cooling is supplied at 30psi in use of the inlet.

### [Example 2]

A test example of continuous plasma generation in the present embodiment is described below. As the vacuum condition, the pressure is 130Pa, and the used gas is N₂ gas. As microwave power, two units were provided for 1000W per unit. As the vacuum pumping system, a rotary pump for the pumping quantity 1000L/min was used. Vacuum was measured by a pirani vacuum gauge on a vacuum exhaust line, and pressure was adjusted by opening and closing adjustment of a manual switching valve on the vacuum exhaust line. Under all of the above conditions, plasma discharge was obtained instantaneously from power-on and plasma which produced plasma emission uniform throughout the vacuum container was obtained. In addition, even if continuous operation is performed for 1000 hours or longer, no problem occurs in the vacuum seal, and no deterioration was observed in the clear silicone O-ring having a hardness of 50 degrees used as the seal O-ring.

In the present embodiment, a process gas inlet 220 and a decompression exhaust port 256 are provided in the same vacuum container wall 259, but they may be provided separately in the vacuum container walls 259 facing each other.

In the present embodiment, the O-ring 58 is provided at the bottom of the groove 231 and configures a seal portion at the end face of the quartz tube 55 but may configure a seal portion on the outer side face or the inner side face near the end face of the quartz tube 55.

### [Third Embodiment]

In the first embodiment, it is possible to realize the input of a large output for a load with a large volume and large area by increasing the diameter of the inner container and coupling a plurality of the high frequency wave coupling portions to the same load. However, since the curvature of the side surface of the inner container becomes constant or more to planarize the side surface by increasing the diameter of the inner container, it become difficult to make an infinitely long dielectric propagation line that the high frequency propagation line is returned in a loop with the dielectric container. Especially, a measure becomes necessary in the application to the decompression plasma reaction processing apparatus which requires the processing in large area.

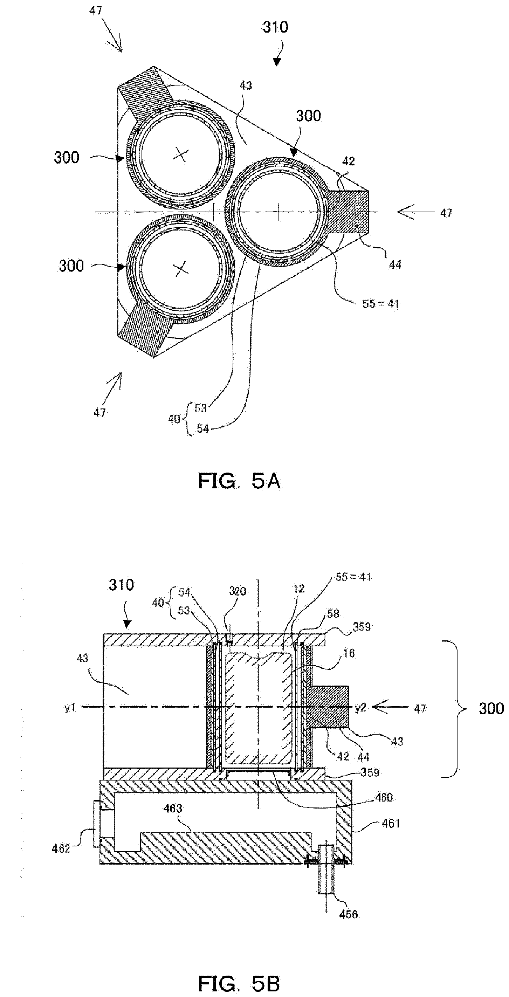

Figs. 5A and 5B are respectively a cross-sectional plan view and a cross-sectional front view on y1-y2 of the high frequency reaction processing system 310 according to the third embodiment. The high frequency reaction processing system 310 comprises a plurality of high frequency reaction processing apparatuses 300 and a single downflow processing chamber container 461. The high frequency reaction processing apparatus 300 comprises a dielectric outer container 40 (outer container), a covering conductor 43 (covering portion), high frequency wave coupling portions 42, a dielectric inner container 41 (inner container) and vacuum container walls 359 (lid portions) . The plurality of high frequency reaction processing apparatuses 300 are formed in the same shape, arranged centrally symmetrically, and share the vacuum container walls 359 with each other. Thus, it is possible to perform the high frequency reaction process in a well-balanced arrangement.

The dielectric outer container 40 is configured of a fluororesin film layer 53 and a quartz tube 54. The dielectric inner container 41 is configured of a quartz tube 55. As shown in Figs. 5A and 5B, the high frequency reaction processing system 310 can configure a discharge portion of the high frequency plasma apparatus.

The downflow processing chamber container 461 is connected to the inner cavity (inner space) of the dielectric inner container 41 via one end face of the dielectric inner container 41 in each of the plurality of high frequency reaction processing apparatuses 300. Thus, a processing reaction with a large output can be expanded to a large area.

The outer containers in the plurality of the high frequency reaction processing apparatuses 300 are cylindrical, and the curvature radiuses of the cylindrical outer containers are 150mm or less. Thus, since it is possible to reduce the curvature radius, the electromagnetic wave can be kept travelling.

The present embodiment is a modification from the first embodiment and aims at processing substrates of the large diameter. Then, the present embodiment has high efficiency and easily realizes a processing apparatus of a large diameter when a plurality of high frequency waves is guided to the same load. The present embodiment is not limited to the modification from the first embodiment and may be a modification from a high frequency reaction processing apparatus without a spatial region or may be a modification from the second embodiment.

As shown in Figs. 5A and 5B, three vacuum containers 12 serving as the center of the plasma discharge portion are configured of three cylindrical quartz tubes 55 and a pair of aluminum vacuum container walls 359 on the upper and lower sides. The quartz tube 55 configures a dielectric inner container 41. The vacuum container 12 is connected to the downflow processing chamber container 461 with a large diameter in the lower aluminum vacuum container wall, and thereby the entire vacuum container is configured.

The high frequency plasma formed in each of the three vacuum containers 12 has a plasma boundary plane 16 and is separated from the downflow processing chamber container 461 by a porous conductor plate 460. In the present embodiment, a high frequency reaction processing system is used as a plasma source of a plasma radical down-flow processing apparatus.

The process to the radical surface processing by the plasma radical down flow processing apparatus is outlined as below. First, a target sample is carried into the sample table 463 in the downflow processing chamber container 461 from the door 462. After the door is closed, gas is exhausted from the decompression exhaust port 456, the pressure is reduced, and the gas for plasma generation is introduced in equal distribution while the flow rate from the three process gas inlets 320 is controlled.

Plasma is formed in each of the vacuum containers 12 by supply of high frequency waves 47 from three oscillation sources. The generated reaction active species is transferred to the downflow processing chamber container 461 which is in a decompression direction through the hole portions of the porous conductor plate 460, and the radical surface reaction processing is performed on the sample.

The configuration of the vacuum container 12 serving as the central part of the discharge portion is the same as that of the first embodiment except for the decompression exhaust port. In the embodiment shown in Figs. 5A and 5B, there is one high frequency waveguide 44 but may be a plurality.

Here, specific dimensions and capacities of the high frequency reaction processing system according to the present embodiment are shown as an example. The frequencies of the high frequency waves 47 of the three oscillation sources are 2.45GHz, their electromagnetic wave mode is TM11 mode, and their maximal power is 1kW. The high frequency wave coupling portion 42 connects to the dielectric outer container 40 at the opening with the width of 70mm and height of 130mm. The dielectric outer container 40 is formed by a quartz tube 54 and a PTFE fluororesin film layer 53 having a thickness of 4mm covering the outer side face of the quartz tube 54 having an outer diameter of 150mm, a thickness of 3mm and a Z-axis length of 200mm. The dielectric inner container 41 is formed of a quartz tube 55 having an outer diameter of 115mm, a thickness of 3mm and a Z-axis direction length of 200mm. The covering conductor 43 made of aluminum is formed by cutting from an integral aluminum block, includes three vacuum containers 12, and is cooled by a water-cooling channel provided therein.

The vacuum container wall 359 made of aluminum is obtained by processing a plate having a thickness of 30mm outer diameter of 380mm. The aluminum vacuum container wall 359 has three holes arranged at equal angles of P.C.D600φ from the center of the integral vacuum container wall on the lower side and is connected to the aluminum downflow processing chamber container 461 by an O-ring seal. Three porous conductor plates 460 are provided at hole positions having a diameter of 100mm at an angular arrangement equal to P.C.D600φ from the center of the vacuum container wall on the lower side. Each of the porous conductor plate 460 is made of stainless steel and is formed in a mesh shape having a porosity of 30% with a thickness of 2mm and a diameter of 100mm. Each of the porous conductor plate 460 separates the plasma formed in the region of the vacuum container 12 between the vacuum container 12 and the downflow processing chamber container 461. The decompression exhaust port 456 is a NW40 bore pipe as a vacuum pipe and is connected to the vacuum pipe from the vacuum pump by a connection joint having an O-ring seal.

To the high frequency waveguide 44, the gas pipe joint with 1/4 inch as the cooling medium inlet is connected. The cooling medium inlet is supplied with dry air at 30psi for cooling.

In the present embodiment, the operating conditions and impedance matching of the ionizing plasma discharges shown in Figs. 5A and 5B are the same as those of the first embodiment.

Thus, a high-performance processing apparatus is realized by mounting the high-efficiency plasma generating source having the high frequency waveguide 44 with a small curvature to the plurality-type identical processing load.

### [Others]

Although quartz is used as a structural material of the dielectric inner container 41 in the above embodiment, other dielectric with low dielectric constant can be used. For example, any alumina-based ceramic can be used. Further, as the dielectric outer container 40 all the dielectric with low dielectric constant can be used. Further, the dielectric outer container 40 may be formed by laminating a plurality of dielectric layers of different materials.

In addition, in the above embodiments, the fluororesin film layer 53 made of PTFE that coats the outer side face of the quartz tube 54 is used in the dielectric outer container 40, but a fluororesin having a depletion layer may be used. In this case, the performance of the dielectric propagation line can be improved by selecting an appropriate depletion rate to adjust the dielectric constant of the fluororesin layer. Alternatively, a thin mica may be coated on the outer side face of the quartz tube 54 in a layered structure. Also, porous ceramics can be used as the dielectric outer container 40 for the same purpose.

Further, in the above embodiments, two high frequency wave coupling portions 42 are provided and arranged symmetrically for the cylindrical axis center, but one or three or more high frequency wave coupling portions around the cylindrical axis may be provided, and further a plurality may be provided in the cylindrical axial direction.

In the above embodiments, all of the dielectric inner container 41, the dielectric outer container 40 and the covering conductor 43 are formed in a cylindrical shape, but they may be formed in an elliptical cylindrical shape. Further, in the dielectric inner container 41 of the above embodiments, the end face is open, but it may be formed also by closing the upper and lower end faces other than the inlet and outlet of the gas. The dielectric inner container 41 of such a shape is preferably made of quartz than alumina in considering ease of manufacture.

This international application claims priority based on Japanese Patent Application No. 2020-51160, filed on March 23, 2020.

### Description of Symbols

- 12: vacuum container
- 16: plasma boundary plane
- 20: process gas inlet
- 40: dielectric outer container
- 41: dielectric inner container
- 42: high frequency wave coupling portion
- 43: covering conductor
- 44: high frequency waveguide
- 47: high frequency wave
- 53: fluororesin film layer
- 54: quartz tube
- 55: quartz tube
- 56: decompression exhaust port
- 57: door sample stage
- 58: O-ring
- 59: vacuum container wall
- 71: cooling medium inlet
- 72: cooling medium outlet
- 100: high frequency reaction processing apparatus
- 149: spatial region
- 200: high frequency reaction processing apparatus
- 220: process gas inlet
- 231: groove
- 256: decompression exhaust port
- 259: vacuum container wall
- 271: cooling medium inlet
- 272: cooling medium outlet
- 300: high frequency reaction processing apparatus
- 310: high frequency reaction processing system
- 320: process gas inlet
- 359: vacuum container wall
- 456: decompression exhaust port
- 460: porous conductor plate
- 461: downflow processing chamber container
- 462: door
- 463: sample stage

## Claims

1. A high frequency reaction processing apparatus (100, 200, 300), comprising:
an outer container (40) made of a dielectric material and having an inner cavity capable of being closed by two end faces,
a covering portion (43) made of a conductive material and kept at the same potential as ground potential of a high frequency waveguide (44),
at least one high frequency wave coupling portion (42) provided at any position of an outer surface of the covering portion, and
at least one inner container (41) made of a dielectric material, provided at a position for receiving a high frequency wave travelling through the high frequency wave coupling portion without touching an inner side face of the outer container (40) and having an inner cavity capable of being closed by two end faces,
a lid portion (59, 259, 359) made of conductor kept at the same potential as ground potential of the high frequency waveguide, the lid portion closing the inner cavity of the inner container at an end face of the inner container,
wherein the lid portion (59, 259, 359) has a fitting groove (231) for fitting an end part of the inner container (41), and the apparatus is configured to perform a reaction process by electromagnetic waves guided from the high frequency wave coupling portion (42) in the inner cavity of the inner container (41), **characterised in that**
the fitting groove (231) has a depth with a length of 1/8 wavelength or more and 1/2 wavelength or less of the guided high frequency wave and accommodates an end part of the inner container (41) without contacting a side surface of the inner container (41).

2. The high frequency reaction processing apparatus according to claim 1, further comprising:
a seal member (58) provided between the inner container (41) and the lid portion (59, 259, 359) for sealing the inner cavity of the inner container,
wherein the seal member (58) is provided at any of positions to be accommodated in the fitting groove (231).

3. The high frequency reaction processing apparatus according to claim 1 or 2,
wherein the inner container (41) is made of alumina.

4. The high frequency reaction processing apparatus according to claim 1 or 2,
wherein the fitting groove (231) has a depth of 1/4 wavelength or more of the guided high frequency wave.

5. The high frequency reaction processing apparatus according to claim 1,
wherein the covering portion forms a spatial region (149) with an outer surface of the outer container (40).

6. The high frequency reaction processing apparatus according to claim 5,
wherein the spatial region (149) is formed by separating the inner surface of the covering portion (43) and the outer surface of the outer container (40) by 1/60 wavelength or more and 1/4 wavelength or less of the travelling high frequency wave.

7. The high frequency reaction processing apparatus according to claim 5 or 6,
wherein the lid portion (59, 259, 359) is provided on each end face of the outer container (40) and the covering portion (43) to close the inner cavity, and
the lid portion (59,259, 359) has a locking portion for holding the outer container (40) apart from the covering portion (43).

8. The high frequency reaction processing apparatus according to any one of claims 1 to 7,
wherein plasma is generated in the inner cavity of the inner container (41).

9. The high frequency reaction processing apparatus according to any one of claims 1 to 7,
wherein reaction processing of a target material is performed by an electromagnetic wave guided from the high frequency wave coupling portion (42) in the inner cavity of the inner container (41).

10. A high frequency reaction processing system comprising:
a plurality of the high frequency reaction processing apparatuses (100, 200, 300) according to any one of claims 1 to 9, and
a single processing chamber (461) connected to the inner cavity of the inner container (41) via an end face on one side of the inner container (41) of each of the plurality of high frequency reaction processing apparatuses (100, 200, 300).

11. The high frequency reaction processing system according to claim 10,
wherein the plurality of the high frequency reaction processing apparatuses (100, 200, 300) is formed in a same shape and arranged centrally symmetrically, and
end faces of the outer container (40) and the inner container (41) are shared with each other.

12. The high frequency reaction processing system according to claim 10 or 11,
wherein the outer containers (40) in the plurality of the high frequency reaction processing apparatuses (100, 200, 300) are cylinders, and
the outer containers (40) of the cylinders have 150mm or less of curvature radiuses.

## Patentansprüche

1. Hochfrequenz-Reaktionsverarbeitungseinrichtung (100, 200, 300), umfassend:
einen äußeren Behälter (40), der aus einem dielektrischen Material hergestellt ist und einen inneren Hohlraum aufweist, der dazu fähig ist, von zwei Endflächen geschlossen zu werden,
einen Abdeckungsabschnitt (43), der aus einem leitenden Material hergestellt ist und auf dem gleichen Potential gehalten wird wie ein Massepotential eines Hochfrequenz-Wellenleiters (44),
mindestens einen Hochfrequenz-Wellenkopplungsabschnitt (42), der an einer beliebigen Position einer äußeren Oberfläche des Abdeckungsabschnitts bereitgestellt ist, und
mindestens einen aus einem dielektrischen Material hergestellten inneren Behälter (41), der an einer Position zum Empfangen einer Hochfrequenzwelle bereitgestellt ist, die sich durch den Hochfrequenz-Wellenkopplungsabschnitt bewegt, ohne eine innere Seitenfläche des äußeren Behälters (40) zu berühren und einen inneren Hohlraum aufweist, der dazu fähig ist, von zwei Endflächen geschlossen zu werden,
einen Deckelabschnitt (59, 259, 359), der aus einem Leiter hergestellt ist, der auf dem gleichen Potential gehalten wird wie ein Massepotential eines Hochfrequenz-Wellenleiters, wobei der Deckelabschnitt den inneren Hohlraum des inneren Behälters an einer Endfläche des inneren Behälters schließt,
wobei der Deckelabschnitt (59, 259, 359) eine Passnut (231) zum Einpassen eines Endteils des inneren Behälters (41) aufweist, und die Einrichtung dazu konfiguriert ist, einen Reaktionsprozess durch elektromagnetische Wellen durchzuführen, die von dem Hochfrequenz-Wellenkopplungsabschnitt (42) in den inneren Hohlraum des inneren Behälters (41) geleitet werden, **gekennzeichnet dadurch, dass**, die Passnut (231) eine Tiefe mit einer Länge von 1/8 Wellenlänge oder mehr und 1/2 Wellenlänge oder weniger als die geleitete Hochfrequenzwelle aufweist und einen Endteil des inneren Behälters (41) aufnimmt, ohne eine Seitenoberfläche des inneren Behälters (41) zu berühren.

2. Hochfrequenz-Reaktionsverarbeitungseinrichtung nach Anspruch 1, ferner umfassend:
ein zwischen dem inneren Behälter (41) und dem Deckelabschnitt (59, 259, 359) bereitgestelltes Dichtungselement (58) zum Abdichten des inneren Hohlraums des inneren Behälters,
wobei das Dichtungselement (58) an einer beliebigen Position bereitgestellt ist, um in der Passnut (231) aufgenommen zu werden.

3. Hochfrequenz-Reaktionsverarbeitungseinrichtung nach Anspruch 1 oder 2, wobei der innere Behälter (41) aus Aluminium hergestellt ist.

4. Hochfrequenz-Reaktionsverarbeitungseinrichtung nach Anspruch 1 oder 2,
wobei die Passnut (231) eine Tiefe von 1/4 Wellenlänge oder mehr der geleiteten Hochfrequenzwelle aufweist.

5. Hochfrequenz-Reaktionsverarbeitungseinrichtung nach Anspruch 1,
wobei der Abdeckungsabschnitt eine räumliche Region (149) mit einer äußeren Oberfläche des äußeren Behälters (40) ausbildet.

6. Hochfrequenz-Reaktionsverarbeitungseinrichtung nach Anspruch 5,
wobei die räumliche Region (149) durch Trennen der inneren Oberfläche des Abdeckungsabschnitts (43) und der äußeren Oberfläche des äußeren Behälters (40) um 1/60 Wellenlänge oder mehr und 1/4 Wellenlänge oder weniger der sich bewegenden Hochfrequenzwelle ausgebildet ist.

7. Hochfrequenz-Reaktionsverarbeitungseinrichtung nach Anspruch 5 oder 6,
wobei der Deckelabschnitt (59, 259, 359) an jeder Endfläche des äußeren Behälters (40) und des Abdeckungsabschnitts (43) bereitgestellt ist, um den inneren Hohlraum zu schließen, und
der Deckelabschnitt (59, 259, 359) einen Verriegelungsabschnitt aufweist, um den äußeren Behälter (40) von dem Abdeckungsabschnitt (43) abzusondern.

8. Hochfrequenz-Reaktionsverarbeitungseinrichtung nach einem der Ansprüche 1 bis 7,
wobei Plasma in dem inneren Hohlraum des inneren Behälters (41) erzeugt wird.

9. Hochfrequenz-Reaktionsverarbeitungseinrichtung nach einem der Ansprüche 1 bis 7,
wobei eine Reaktionsverarbeitung eines Zielmaterials durch eine elektromagnetische Welle durchgeführt wird, die von dem Hochfrequenz-Wellenkopplungsabschnitt (42) in dem inneren Hohlraum des inneren Behälters (41) geleitet wird.

10. Hochfrequenz-Reaktionsverarbeitungssystem, umfassend:
eine Vielzahl der Hochfrequenz-Reaktionsverarbeitungseinrichtungen (100, 200, 300) nach einem der Ansprüche 1 bis 9, und
eine einzelne Verarbeitungskammer (461), die mit dem inneren Hohlraum des inneren Behälters (41) über eine Endfläche auf einer Seite des inneren Behälters (41) von jeder der Vielzahl von Hochfrequenz-Reaktionsverarbeitungseinrichtungen (100, 200, 300) verbunden ist.

11. Hochfrequenz-Reaktionsverarbeitungssystem nach Anspruch 10,
wobei die Vielzahl der Hochfrequenz-Reaktionsverarbeitungseinrichtungen (100, 200, 300) in einer gleichen Form ausgebildet und zentral symmetrisch angeordnet sind, und
Endflächen des äußeren Behälters (40) und des inneren Behälters (41) miteinander geteilt werden.

12. Hochfrequenz-Reaktionsverarbeitungssystem nach Anspruch 10 oder 11,
wobei die äußeren Behälter (40) in der Vielzahl der Hochfrequenz-Reaktionsverarbeitungseinrichtungen (100, 200, 300) Zylinder sind, und
die äußeren Behälter (40) der Zylinder Krümmungsradien von 150 mm oder weniger aufweisen.

## Revendications

1. Appareil de traitement par réaction haute fréquence (100, 200, 300), comprenant :
un récipient externe (40) constitué d'un matériau diélectrique et présentant une cavité interne pouvant être fermée par deux faces d'extrémité,
une partie de revêtement (43) constituée d'un matériau conducteur et maintenue au même potentiel que le potentiel de masse d'un guide d'ondes haute fréquence (44),
au moins une partie de couplage d'ondes haute fréquence (42) prévue à n'importe quelle position d'une surface externe de la partie de revêtement, et
au moins un récipient interne (41) constitué d'un matériau diélectrique, prévu à une position pour recevoir une onde haute fréquence progressant à travers la partie couplage d'ondes haute fréquence sans toucher une face latérale interne du récipient externe (40) et présentant une cavité interne pouvant être fermée par deux faces d'extrémité,
une partie couvercle (59, 259, 359) constituée d'un conducteur maintenu au même potentiel que le potentiel de masse du guide d'ondes haute fréquence, la partie couvercle fermant la cavité interne du récipient interne au niveau d'une face d'extrémité du récipient interne,
dans lequel la partie couvercle (59, 259, 359) présente une rainure d'ajustement (231) pour ajuster une partie d'extrémité du récipient interne (41), et l'appareil est configuré pour effectuer un processus de réaction par des ondes électromagnétiques guidées à partir de la partie de couplage d'ondes haute fréquence (42) dans la cavité interne du récipient interne (41), **caractérisé en ce que** la rainure d'ajustement (231) présente une profondeur avec une longueur de 1/8 de longueur d'onde ou plus et de 1/2 longueur d'onde ou moins de l'onde haute fréquence guidée et loge une partie d'extrémité du récipient interne (41) sans entrer en contact avec une surface latérale du récipient interne (41).

2. Appareil de traitement par réaction haute fréquence selon la revendication 1, comprenant en outre :
un élément joint d'étanchéité (58) prévu entre le récipient interne (41) et la partie couvercle (59, 259, 359) pour assurer l'étanchéité de la cavité interne du récipient interne,
dans lequel l'élément joint d'étanchéité (58) est prévu à n'importe quelle des positions pour être logé dans la rainure d'ajustement (231).

3. Appareil de traitement par réaction haute fréquence selon la revendication 1 ou 2, dans lequel le récipient interne (41) est en alumine.

4. Appareil de traitement par réaction haute fréquence selon la revendication 1 ou 2,
dans lequel la rainure d'ajustement (231) présente une profondeur de 1/4 de longueur d'onde ou plus de l'onde haute fréquence guidée.

5. Appareil de traitement par réaction haute fréquence selon la revendication 1,
dans lequel la partie de revêtement forme une région spatiale (149) avec une surface externe du récipient externe (40).

6. Appareil de traitement par réaction haute fréquence selon la revendication 5,
dans lequel la région spatiale (149) est formée en séparant la surface interne de la partie de revêtement (43) et la surface externe du récipient externe (40) de 1/60 de longueur d'onde ou plus et de 1/4 de longueur d'onde ou moins de l'onde haute fréquence progressive.

7. Appareil de traitement par réaction haute fréquence selon la revendication 5 ou 6,
dans lequel la partie couvercle (59, 259, 359) est prévue sur chaque face d'extrémité du récipient externe (40) et la partie de revêtement (43) pour fermer la cavité interne, et
la partie couvercle (59, 259, 359) présente une partie de verrouillage pour maintenir le récipient externe (40) à l'écart de la partie de revêtement (43).

8. Appareil de traitement par réaction haute fréquence selon l'une quelconque des revendications 1 à 7,
dans lequel le plasma est généré dans la cavité interne du récipient interne (41).

9. Appareil de traitement par réaction haute fréquence selon l'une quelconque des revendications 1 à 7,
dans lequel le traitement par réaction d'un matériau cible est effectué par une onde électromagnétique guidée à partir de la partie de couplage d'ondes haute fréquence (42) dans la cavité interne du récipient interne (41).

10. Système de traitement par réaction haute fréquence comprenant :
une pluralité des appareils de traitement par réaction haute fréquence (100, 200, 300) selon l'une quelconque des revendications 1 à 9, et
une chambre de traitement unique (461) reliée à la cavité interne du récipient interne (41) via une face d'extrémité sur un côté du récipient interne (41) de chacun de la pluralité d'appareils de traitement par réaction haute fréquence (100, 200, 300).

11. Système de traitement par réaction haute fréquence selon la revendication 10,
dans lequel la pluralité des appareils de traitement par réaction haute fréquence (100, 200, 300) est formée dans une même forme et agencée symétriquement de manière centrale, et
les faces d'extrémité du récipient externe (40) et du récipient interne (41) sont partagées entre eux.

12. Système de traitement par réaction haute fréquence selon la revendication 10 ou 11,
dans lequel les récipients externes (40) dans la pluralité des appareils de traitement par réaction haute fréquence (100, 200, 300) sont des cylindres, et
les récipients externes (40) des cylindres présentent des rayons de courbure de 150 mm ou moins.
